# EUROPÄISCHE PATENTSCHRIFT

(11) **EP 3 296 669 B1**
(45) Veröffentlichungstag und Bekanntmachung des Hinweises auf die Patenterteilung: **13.02.2019**
(21) Anmeldenummer: 17191011.0
(22) Anmeldetag: 14.09.2017
(51) Int. Cl.: F25D 19/00, F25B 49/00, H01F 6/04

(54) **KRYOSTATENANORDNUNG MIT EINEM VAKUUMBEHÄLTER UND EINEM ZU KÜHLENDEN OBJEKT, MIT EVAKUIERBAREM HOHLRAUM**
CRYOSTAT ASSEMBLY WITH A VACUUM CONTAINER AND AN OBJECT TO BE COOLED, WITH CAVITY WHICH CAN BE EVACUATED
ENSEMBLE CRYOSTAT DOTÉ D'UN RÉSERVOIR À VIDE ET D'UN OBJET À REFROIDIR ET DOTÉ D'UN ESPACE CREUX POUVANT ÊTRE VIDÉ

(30) Priorität: 20.09.2016 DE 102016218000
(43) Veröffentlichungstag der Anmeldung: 21.03.2018
(73) Patentinhaber: Bruker BioSpin GmbH, 76287 Rheinstetten (DE)
(72) Erfinder: WIKUS, Patrick, 8309 Nürensdorf (CH); BONN, Steffen, 8050 Zürich (CH)
(74) Vertreter: Kohler Schmid Möbus Patentanwälte

(56) Entgegenhaltungen:
- EP-A2- 1 557 624
- GB-A- 2 414 538
- GB-A- 2 457 054
- GB-A- 2 525 216
- JP-A- H05 243 042
- JP-A- 2005 055 003
- CATARINO ET AL: "Neon gas-gap heat switch", CRYOGENICS, ELSEVIER, KIDLINGTON, GB, Bd. 48, Nr. 1-2, 1. Januar 2008 (2008-01-01), Seiten 17-25, XP022490178, ISSN: 0011-2275, DOI: 10.1016/J.CRYOGENICS.2007.09.002

## Beschreibung

Die Erfindung betrifft eine Kryostatenanordnung, mit einem Vakuumbehälter und einem zu kühlenden Objekt, insbesondere einem supraleitenden Magnetspulensystem oder einem Kryobehälter,
wobei das zu kühlende Objekt innerhalb des Vakuumbehälters angeordnet ist, wobei der Vakuumbehälter ein Halsrohr aufweist, das zum zu kühlenden Objekt führt,
wobei ein Kühlarm eines Kaltkopfs zumindest teilweise im Halsrohr angeordnet ist,
wobei um den Kühlarm herum ein abgeschlossener Hohlraum ausgebildet ist, der gegenüber dem zu kühlenden Objekt fluiddicht abgedichtet ist,
wobei der Hohlraum im Normalbetrieb zumindest teilweise mit einem ersten kryogenen Fluid gefüllt ist,
und wobei ein erstes thermisches Kopplungsmittel vorgesehen ist, geeignet zur thermischen Kopplung des ersten kryogenen Fluids im Hohlraum mit dem zu kühlenden Objekt.

Eine solche Kühlvorrichtung ist aus der DE102014218773A1 , JP2005055003 und GB2457054 bekannt geworden.

Kernspinresonanz(=NMR)-Apparaturen, insbesondere NMR-Spektrometer und NMR-Tomographen, benötigen starke Magnetfelder, die oftmals mittels supraleitender Magnetspulen erzeugt werden. Die supraleitenden Magnetspulen müssen auf einer kryogenen Temperatur betrieben werden. Die Magnetspulen sind dafür typischerweise in einem Kryostaten angeordnet. Der Kryostat weist einen evakuierten Behälter ("Vakuumbehälter") auf, in welchem ein zu kühlendes Objekt angeordnet ist, oft noch umgeben von einem Strahlungsschild. Das zu kühlende Objekt kann die Magnetspule selbst sein ("cryofree"- System), oder auch ein Kryobehälter, in welchem eine kryogene Flüssigkeit (etwa flüssiges Helium) und die Magnetspule angeordnet sind.

Das zu kühlende Objekt wird in der Regel mit einem aktiven Kühlsystem, meist umfassend einen Pulsrohrkühler oder einen Gifford-MacMahon Kühler, gekühlt. Aktive Kühlsysteme reduzieren den Verbrauch an teurem flüssigem Helium, erhöhen die Verfügbarkeit der NMR-Apparatur und können auch zur Reduktion der Bauhöhe beitragen. Das aktive Kühlsystem kann einstufig oder auch mehrstufig ausgebildet sein. Bei mehrstufigen Systemen kühlt meist eine wärmere Kaltstufe den thermischen Strahlungsschild und eine kältere Kaltstufe das zu kühlende Objekt.

Bei Ausfall des aktiven Kühlsystems, etwa aufgrund eines technischen Defekts, sollten die supraleitende Magnetspule oder die supraleitenden Magnetspulen ("supraleitendes Magnetspulensystem") so lange unterhalb der Sprungtemperatur verbleiben können, bis eine Reparatur des aktiven Kühlsystems vorgenommen werden kann. Ein Verlust des supraleitenden Zustands infolge einer Erwärmung kann zur Zerstörung des supraleitenden Magnetspulensystems führen; zumindest aber wäre ein erneutes Abkühlen des supraleitenden Magnetspulensystems mit beträchtlichem Aufwand verbunden.

Bei den häufigsten Bauformen von Kryostaten mit aktiver Kühlung, vgl. die US 2007/089432 A, ragt der Kühlarm eines Kühlkopfes in ein Halsrohr eines Vakuumbehälters. Das Halsrohr ist zu einem Kryobehälter hin offen, in welchem eine supraleitende Magnetspule in flüssigem Helium angeordnet ist. An der untersten Kühlstufe des Kühlarms rekondensiert Helium und tropft in den Kryobehälter zurück. Ähnliche Kryostaten sind aus der US 2010/298148 A, der US 2007/022761A, der DE 10 2004 012 416 B4 oder der US 2007/051115 A bekannt geworden.

Um die verfügbare Zeit zwischen einem Ausfall eines aktiven Kühlsystems und einer Serviceintervention möglichst lange zu gestalten, können die thermischen Massen (d.h. die Masse multipliziert mit der spezifischen Wärmekapazität) im Kryostaten, etwa eines Strahlungsschildes oder eines Kryobehälters einschließlich kryogener Flüssigkeit, groß gewählt werden, was aber die Bauhöhe und das Gesamtgewicht des Kryostaten vergrößert. Ebenso kann bei Kryostaten mit Kryobehälter extern beschafftes flüssiges Helium nachgefüllt werden, um abgedampftes Helium zu ersetzen; dies ist allerdings sehr teuer.

Aus der US 8,950,194 B2 ist es bekannt geworden, bei abgeschaltetem Kühler etwa während eines Transports einen Teil des abdampfenden Gases aus dem Kryobehälter entlang des Kühlers zu leiten, und so die Wärmelast des Kühlarms zu verringern.

Aus der DE 10 2014 218 773 A1 ist es bekannt, bei einem Kryostaten ein Hohlvolumen zwischen der Innenseite des Halsrohrs und dem Kühlarm eines Kühlkopfes mit einem Gas, etwa Helium, zu füllen. Im Normalbetrieb befindet sich die unterste Kühlstufe des Kühlarms nahe dem zu kühlenden Objekt; beispielsweise wird eine enge thermische Kopplung über einen Kontakt des zu kühlenden Objekts und der untersten Kühlstufe zu einer geringen Menge flüssigen Heliums im Hohlvolumen hergestellt. Bei Ausfall der Kühlung steigt der Gasdruck im Hohlvolumen in Folge der Erwärmung an; etwaiges flüssiges Helium im Hohlvolumen verdampft. Der verschiebbar gelagerte Kühlkopf wird durch den gestiegenen Gasdruck im Hohlvolumen in Richtung vom zu kühlenden Objekt weg bewegt, wodurch die thermische Kopplung von Kühlarm und zu kühlendem Objekt verringert wird.

Mit diesem Kryostaten kann die Wärmelast durch einen Kühlarm bei Ausfall der aktiven Kühlung verringert werden, jedoch ist der bauliche Aufwand durch die verfahrbare Aufhängung des Kaltkopfs vergleichsweise groß. Zudem bleibt aufgrund des hohen Gasdrucks im Hohlvolumen weiterhin eine nicht unerhebliche thermische Kopplung bestehen.

### Aufgabe der Erfindung

Der Erfindung liegt die Aufgabe zugrunde, eine Kryostatenanordnung vorzustellen, bei der auf einfache Weise die Wärmelast durch einen Kühlarm bei Ausfall der aktiven Kühlung weiter verringert werden kann.

### Kurze Beschreibung der Erfindung

Diese Aufgabe wird auf überraschend einfache und wirkungsvolle Weise gelöst durch eine Kryostatenanordnung gemäß Anspruch1.

Erfindungsgemäß ist vorgesehen, den Kühlarm mit einem Hohlraum zu umgeben, der im Normalbetrieb für eine gute thermische Kopplung des Kühlarms mit dem zu kühlenden Objekt zumindest teilweise mit einem ersten kryogenen Fluid gefüllt ist. Die wesentliche thermische Kopplung vom Kühlarm zum zu kühlenden Objekt findet durch den Hohlraum hindurch mittels des ersten kryogenen Fluids statt. Der Wärmeübergang wird dabei vor allem durch Konvektion und Wärmeleitung im kryogenen Fluid getragen. Besonders gute Wärmeleitung kann mit verflüssigtem kryogenen Fluid erzielt werden, wofür ein entsprechender Gasdruck eingestellt werden kann (etwa mit Heizern an geeigneten Stellen). Der Hohlraum ist gegenüber dem zu kühlenden Objekt abgedichtet, das heißt das erste kryogene Fluid kann nicht in das zu kühlende Objekt eindringen. Falls gewünscht kann jedoch im Rahmen der Erfindung eine Außenwand des zu kühlenden Objekts den Hohlraum mit begrenzen; jedoch kommuniziert das erste kryogene Fluid nicht mit einem etwaigen zweiten kryogenen Fluid im zu kühlenden Objekt (etwa einem Heliumtank).

Bei Ausfall der aktiven Kühlung kann dieser Hohlraum mit der Pumpvorrichtung evakuiert werden. Bei Vakuum im Hohlraum (meist um 1 mbar oder noch weniger, oft auch 10⁻² mbar oder noch weniger) wird die thermische Kopplung zwischen Kühlarm und zu kühlendem Objekt unterbrochen oder zumindest stark reduziert (typischerweise um 70% oder noch mehr, oft um 95% oder noch mehr, bevorzugt um 99% oder noch mehr); das Vakuum wirkt thermisch isolierend.

In Abwesenheit des ersten kryogenen Fluids wird der abgeschlossene Hohlraum zum Isolationsvakuum. Von den drei Wärmetransportmechanismen durch den Hohlraum (Wärmeleitung, Konvektion, Wärmestrahlung) entfallen im evakuierten Zustand/Störungsbetrieb die zwei, die in der Regel im Normalbetrieb dominieren (Wärmeleitung und Konvektion), und als einziger Wärmetransportmechanismus von praktisch relevanter Bedeutung verbleibt Wärmestrahlung . Der strahlungsvermittelte Wärmeeintrag kann, falls gewünscht, durch Baffles / offene Strahlungsschilde weiter reduziert werden, die im Normalbetrieb von dem ersten kryogenen Fluid umströmt werden und den thermischen Kontakt dann nur geringfügig beeinträchtigen.

Infolgedessen führt der nicht mehr aktiv gekühlte Kühlarm (dessen Temperatur allmählich ansteigt, ggf. bis auf Raumtemperatur) nur noch zu einer vergleichsweise geringen Wärmelast für das zu kühlende Objekt. Durch das Evakuieren des gegenüber dem zu kühlenden Objekts abgedichteten Hohlraums wird das zu kühlende Objekt nicht beeinträchtigt, insbesondere wird ein etwaiges zweites, im zu kühlenden Objekt eingesetztes kryogenes Fluid (etwa ein Heliumbad) nicht mit abgepumpt.

Das erste kryogene Fluid ist typischerweise gasförmig oder teilweise gasförmig und teilweise flüssig. Das erste kryogene Fluid ist typischerweise Helium. Entsprechendes gilt ggf. für das zweite und dritte kryogene Fluid (siehe unten).

Der Kühlarm ist im Normalbetrieb direkt oder indirekt thermisch an das erste kryogene Fluid im Hohlraum gekoppelt, und ist dadurch auch indirekt thermisch an das zu kühlende Objekt gekoppelt. Im Störungsfall (Ausfall der Kühlvorrichtung) kann das erste kryogene Fluid abgepumpt werden, wodurch die thermische Kopplung des (sich erwärmenden) Kühlarms an das zu kühlende Objekt aufgehoben oder zumindest stark verringert wird.

Der Kühlarm berührt typischerweise weder im Normalbetrieb noch im Störungsfall das erste thermische Kopplungsmittel (und typischerweise auch nicht ein etwaiges zweites thermisches Kopplungsmittel, siehe unten).

Der Kühlarm kann unmittelbar/direkt oder mittelbar/indirekt (etwa in einem Kühlarmbehälter, der wiederum vom Hohlraum umgeben ist) vom Hohlraum umgeben sein. Weiterhin kann der Kühlarm oder ein Teil desselben unmittelbar/direkt oder mittelbar/indirekt (etwa in einem Kühlarmbehälter, der seinerseits zumindest teilweise im Halsrohr angeordnet ist) im Halsrohr angeordnet sein.

### Bevorzugte Ausführungsformen der Erfindung

### Ausführungsformen, bei denen der Kühlarm unmittelbar im zu evakuierenden Hohlraum angeordnet ist

Bei einer bevorzugten Ausführungsform der erfindungsgemäßen Kryostatenanordnung ist der Kühlarm des Kaltkopfs unmittelbar in dem Hohlraum angeordnet. Dadurch ist ein besonders einfacher Aufbau möglich, und die thermische Masse von Strukturen, die sich bei Ausfall der aktiven Kühlung des Kühlarms erwärmen, kann minimiert werden. Zudem gestattet dieser Aufbau meist eine besonders gute thermische Kopplung von Kühlarm und zu kühlendem Objekt im Normalbetrieb. Der Hohlraum kann außenseitlich oder auch ganz durch das Halsrohr ausgebildet werden.

Bei einer vorteilhaften Weiterbildung dieser Ausführungsform ist vorgesehen, dass eine äußere Einfassung des Hohlraums von einer Innenwand des Halsrohrs beabstandet ist, und ein Zwischenraum zwischen der Innenwand des Halsrohrs und der Einfassung zum zu kühlenden Objekt hin offen ausgebildet ist,
wobei das zu kühlende Objekt, zu dem der Zwischenraum hin offen ist, ein Kryobehälter ist, der zumindest teilweise mit einem zweiten kryogenen Fluid gefüllt ist,
insbesondere wobei der Zwischenraum eine Zuführung für einzuführendes oder rückzuführendes zweites kryogenes Fluid aufweist. Der Zwischenraum zwischen der Einfassung und der Innenwand des Halsrohrs kann für eine Einführung oder Rückführung des zweiten kryogenen Fluids in den Kryobehälter genutzt werden. Dies ermöglicht die Abkühlung des zweiten kryogenen Fluids sowie dessen Kondensation an der kalten Außenseite der Einfassung. Zudem ist die Einfassung von der Innenseite des Halsrohrs beabstandet, wodurch eine Übertragung von etwaigen mechanischen Vibrationen von der Einfassung auf den übrigen Kryostaten erschwert wird.

Bei einer besonders bevorzugten Weiterentwicklung dieser Weiterbildung ist der Kaltkopf einschließlich der Einfassung des Hohlraums von der übrigen Kryostatenanordnung einschließlich des zu kühlenden Objekts mechanisch entkoppelt gelagert, wobei eine flexible Membran vorgesehen ist, die den Zwischenraum gegenüber der Umgebung abdichtet. Durch die mechanische entkoppelte Lagerung wird ein Eintrag von mechanischen Schwingungen vom Kaltkopf (etwa basierend auf Druckpulsen des Arbeitsgases eines Pulsrohrkühlers) in den Kryostaten verhindert oder zumindest vermindert. In dem Zwischenraum kann, aufgrund der Verbindung zum Kryobehälter, das zweite Kryofluid unter einem Gasdruck nahe dem Umgebungsdruck gehalten werden (Druckdifferenz meist < 50 mbar oder < 25 mbar, wobei meist ein geringfügig höherer Gasdruck in dem Zwischenraum herrscht), wodurch die flexible Membran praktisch spannungsfrei ist und eine Übertragung von mechanischen Vibrationen in den Kryostaten auch hier vermieden wird. Die flexible Membran wird von einer etwaigen Evakuierung des Hohlraums mechanisch nicht betroffen.

Vorteilhaft ist auch eine Weiterbildung, bei der die Einfassung des Hohlraums einen elastisch längenveränderlichen Abschnitt sowie Zwischenkontaktelement zur Kontaktierung einer oberen Kaltstufe des Kühlarms aufweist, derart, dass im Normalbetrieb das Zwischenkontaktelement an der oberen Kaltstufe am Kühlarm anliegt, und bei evakuiertem Hohlraum aufgrund einer veränderten Druckdifferenz zwischen Hohlraum und Kryobehälter ein Teil der Einfassung einschließlich des Zwischenkontaktelements verschoben ist, so dass die obere Kühlstufe nicht mehr am Zwischenkontaktelement anliegt. Dadurch kann die thermische Entkopplung im Störungsfall verbessert werden. Das Zwischenkontaktelement liegt typischerweise einem Schildkontaktelement eines Strahlungsschilds des Vakuumbehälters zur thermischen Kopplung gegenüber, bevorzugt wobei eine gegenseitige Beabstandung aufgrund der Verschiebung des Teils der Einfassung im Normalbetrieb geringer ist als im Störungsfall mit evakuiertem Vakuumbehälter. Im Normalbetrieb kann auch eine gegenseitige Berührung von Schildkontaktelement und Zwischenkontaktelement vorliegen.

### Ausführungsformen, bei denen der Kühlarm mittelbar im zu evakuierenden Hohlraum angeordnet ist

Bei einer vorteilhaften Ausführungsform ist vorgesehen, dass der Kühlarm unmittelbar in einem Kühlarmbehälter angeordnet ist, wobei der Hohlraum um den Kühlarmbehälter herum ausgebildet ist,
dass der Kühlarmbehälter fluiddicht gegenüber dem Hohlraum abgedichtet ist, und dass ein zweites thermisches Kopplungsmittel vorgesehen ist, geeignet zur thermischen Kopplung des ersten kryogenen Fluids im Hohlraum mit dem Innenraum des Kühlarmbehälters,
insbesondere wobei im Kühlarmbehälter ein drittes kryogenes Fluid angeordnet ist. Bei dieser Ausführungsform ist der Innenraum des Kühlarmbehälters separat vom Hohlraum, wodurch Manipulationen am Kühlarm, etwa bei Reparaturen, vereinfacht sind. Ein Gasdruck kann im Kühlraumbehälter unabhängig vom Gasdruck im Hohlraum eingestellt werden. Ebenso wird eine mechanische Entkopplung des Kühlarms vom übrigen Kryostaten, insbesondere auch vom Hohlraum bzw. dessen Einfassung, vereinfacht.

Bei einer besonders bevorzugten Weiterbildung dieser Ausführungsform ist der Kaltkopf von der Wand des Kühlarmbehälters und der übrigen Kryostatenanordnung einschließlich des zu kühlenden Objekts mechanisch entkoppelt gelagert, wobei eine flexible Membran einen Ringspalt zwischen der Wand des Kühlarmbehälters und dem Kaltkopf überspannt und so den Innenraum des Kühlarmbehälters gegen die Umgebung abdichtet. Die mechanisch entkoppelte Lagerung verhindert oder verringert den Eintrag von mechanischen Schwingungen (etwa aufgrund von Druckpulsen eines Arbeitsgases in einem Pulsrohrkühler) in den Kryostaten. Im Kühlraumbehälter kann das dritte Kryofluid unter einem Gasdruck nahe dem Umgebungsdruck gehalten werden (Druckdifferenz meist < 50 mbar oder < 25 mbar, wobei meist ein geringfügig höherer Gasdruck in dem Kühlarmbehälter herrscht), wodurch die flexible Membran praktisch spannungsfrei ist und eine Übertragung von mechanischen Vibrationen in den Kryostaten auch hier vermieden wird. Die flexible Membran wird von einer etwaigen Evakuierung des Hohlraums mechanisch nicht betroffen.

### Diverse Ausführungsformen

Vorteilhaft ist eine Ausführungsform, bei der das erste thermische Kopplungsmittel und/oder das zweite thermische Kopplungsmittel als ein Wärmetauscher ausgebildet ist, insbesondere wobei der Wärmetauscher oberflächenvergrößernde Strukturen, bevorzugt Rippen, aufweist. Durch einen Wärmetauscher kann die thermische Kopplung zwischen zu kühlendem Objekt und dem ersten kryogenen Fluid im Hohlraum verbessert werden. Der erste Wärmetauscher basiert typischerweise auf einem (bei kryogenen Temperaturen) gut wärmeleitfähigem Material, beispielsweise Kupfer, und hat bevorzugt berührenden Kontakt sowohl zum ersten kryogenen Fluid im Hohlraum als auch zum zu kühlenden Objekt (insbesondere einer zweiten kryogenen Flüssigkeit) ; entsprechendes gilt für den zweiten Wärmetauscher.

Bevorzugt ist weiterhin eine Ausführungsform, bei der das zu kühlende Objekt ein Kryobehälter ist, und eine äußere Einfassung des Hohlraums in einen oberen Bereich des Kryobehälters hineinragt. Falls ein Kühlarmbehälter vorgesehen ist, ragt dieser bevorzugt ebenfalls in den oberen Bereich des Kryobehälters hinein. Bei dieser Ausführungsform kann ein großflächiger thermischer Kontakt zwischen dem ersten kryogenen Fluid im Hohlraum und dem Kryobehälter bzw. einem darin enthaltenen zweiten kryogenen Fluid eingerichtet werden. Zudem kann eine geringe Bauhöhe erreicht werden. Eine bevorzugte Weiterbildung dieser Ausführungsform sieht vor, dass im Normalbetrieb im Hohlraum eine erste kryogene Flüssigkeit angeordnet ist, dass im Kryobehälter eine zweite kryogene Flüssigkeit angeordnet ist, und dass die äußere Einfassung des Hohlraums in die zweite kryogene Flüssigkeit im Kryobehälter eintaucht. Die beiden kryogenen Flüssigkeiten gestatten eine besonders gute thermische Kopplung. Im Wesentlichen kann hier das erste thermische Kopplungsmittel durch den in die zweite kryogene Flüssigkeit im Kryobehälter eintauchenden Teil der äußeren Einfassung ausgebildet werden. Bevorzugt ist der eintauchende Teil der äußeren Einfassung zumindest in einem Abschnitt beidseitg von kryogener Flüssigkeit benetzt.

Bei einer Weiterentwicklung hierzu, mit unmittelbar den Kühlarm umgebendem Hohlraum, taucht zumindest eine unterste Kaltstufe des Kühlarms in die erste kryogene Flüssigkeit im Hohlraum ein. Hierdurch kann die thermische Kopplung der untersten Kaltstufe (Kühlstufe) an das zu kühlende Objekt verbessert werden.

Bei einer anderen Weiterentwicklung, mit Kühlarm in einem Kühlarmbehälter, der wiederum vom Hohlraum umgeben wird, ist vorgesehen, dass der Kühlarmbehälter in die erste kryogene Flüssigkeit im Hohlraum eintaucht, und dass im Kühlarmbehälter eine dritte kryogene Flüssigkeit angeordnet ist, in welche zumindest eine unterste Kaltstufe des Kühlarms eintaucht. Auch hierdurch kann die thermische Kopplung der untersten Kaltstufe (Kühlstufe) an das zu kühlende Objekt verbessert werden. Im Wesentlichen kann hier das zweite thermische Kopplungsmittel durch den in die erste kryogene Flüssigkeit im Hohlraum eintauchenden Teil des Kühlarmbehälters ausgebildet werden. Bevorzugt ist der eintauchende Teil des Kühlraumbehälters zumindest in einem Abschnitt beidseitig von kryogener Flüssigkeit benetzt.

Es ist eine Überwachungseinrichtung vorgesehen, die die Kühlfunktion des Kaltkopfs überwacht, und die dazu ausgebildet ist, bei Ausfall der Kühlfunktion des Kaltkopfs die Pumpvorrichtung selbsttätig zu aktivieren, so dass der Hohlraum evakuiert wird. Hierdurch kann die Wärmelast durch einen sich erwärmenden Kühlarm frühzeitig reduziert werden und so die mögliche Haltezeit, über die das zu kühlende Objekt auf kryogener Temperatur gehalten werden kann (und insbesondere ein Quench in einem supraleitenden Magnetspulensystem verhindert werden kann), verlängert werden. Die Überwachungseinrichtung kann am einfachsten eine Temperatur an einem geeigneten Ort des Kühlarms überwachen, oder auch geeignete elektrische Kontrollmessungen am aktiven Kühlsystem vornehmen. In der Regel öffnet die Überwachungseinrichtung auch noch ein Absperrventil zwischen der Pumpvorrichtung und dem Hohlraum (etwa in einer Pumpleitung), wenn sie die Pumpvorrichtung aktiviert.

Bei einer bevorzugten Ausführungsform ist die Pumpvorrichtung als eine Sorptionspumpe ausgebildet, deren pumpende Kaltflächen thermisch an das zu kühlende Objekt gekoppelt sind, insbesondere wobei eine Verbindungsleitung vom Hohlraum zu den pumpenden Kaltflächen vollständig innerhalb des Vakuumbehälters verläuft. Die pumpenden Kaltflächen sind beispielsweise in einem Aktivkohle- oder Zeolithbehälter ausgebildet. Die Sorptionspumpe (oder "Kryopumpe") hat die pumpenden Kaltflächen oder deren Behälter typischerweise in berührendem Kontakt zum zu kühlenden Objekt. Die Verbindungsleitung (Pumpleitung) vom Hohlraum zu den pumpenden Kaltflächen im Behälter (Sorptionsbehälter) ist bevorzugt vollständig innerhalb des Vakuumbehälters ausgebildet und weist typischerweise einen Wärmetauscher auf, der das abgesaugte Gas vor Erreichen des Behälters vorkühlt.

Bevorzugt ist auch eine Ausführungsform, bei der es sich bei dem zu kühlenden Objekt um einen Kryobehälter handelt, der zumindest teilweise mit einem zweiten kryogenen Fluid gefüllt ist, insbesondere wobei in dem Kryobehälter ein supraleitendes Magnetspulensystem angeordnet ist. Dies ist ein häufiger Kryostatenaufbau, der eine zuverlässige und gleichmäßige Kühlung von im Kryobehälter angeordneten Strukturen gestattet. Der Kryostatenaufbau gestattet auch eine Notkühlung durch einfaches (wenngleich teures) Nachfüllen von flüssigem Helium aus einem externen Vorrat. Der Hohlraum mit dem ersten kryogenen Fluid ist von dem Kryobehälter mit dem zweiten kryogenen Fluid fluiddicht abgetrennt. Das erste und zweite kryogene Fluid können jedoch gleich gewählt werden, etwa zu Helium. Typischerweise trennt das erste thermische Kopplungsmittel den Hohlraum vom Kryobehälter ab.

Bei einer alternativen Ausführungsform handelt es sich bei dem zu kühlenden Objekt um ein supraleitendes Magnetspulensystem, das unmittelbar im Vakuumbehälter angeordnet ist. Das Magnetspulensystem (oder ein anderes zu kühlendes Objekt) ist in diesem "Cryo-free"-System unmittelbar im Vakuum des Vakuumbehälters angeordnet, was den Aufbau des Kryostaten vereinfacht. Man beachte, dass das Magnetspulensystem ein Gehäuse aufweisen kann; in diesem ist jedoch kein kryogenes Fluid zur Kühlung vorgesehen.

### Erfindungsgemäßes Betriebsverfahren

In den Rahmen der vorliegenden Erfindung fällt auch ein Verfahren zum Betrieb einer Kryostatenanordnung, insbesondere einer erfindungsgemäßen, oben beschriebenen Kryostatenanordnung, gemäß Anspruch 14. Durch das Evakuieren wird das erste kryogene Fluid aus dem Hohlraum entfernt, wodurch die Kopplung des Kühlarms bzw. des Kaltkopfs zum zu kühlenden Objekt aufgehoben oder stark verringert wird. Der Hohlraum bleibt typischerweise evakuiert, bis die Kühlfunktion des Kaltkopfs wieder hergestellt worden ist.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen schematischen Querschnitt einer ersten Ausführungsform einer erfindungsgemäßen Kryostatenanordnung, mit einer supraleitenden Magnetspule unmittelbar im Vakuum als zu kühlendem Objekt;
- Fig. 2: einen schematischen Querschnitt einer zweien Ausführungsform einer erfindungsgemäßen Kryostatenanordnung, mit einem Kryobehälter als zu kühlendem Objekt, wobei im Kryobehälter eine supraleitende Magnetspule enthalten ist;
- Fig. 3-8: schematische Querschnitte durch den Bereich des Halsrohrs von erfindungsgemäßen Kryostatenanordnungen, jeweils linksseitig im Normalbetrieb und rechtsseitig im Störungsfall mit abgepumptem Hohlraum, mit

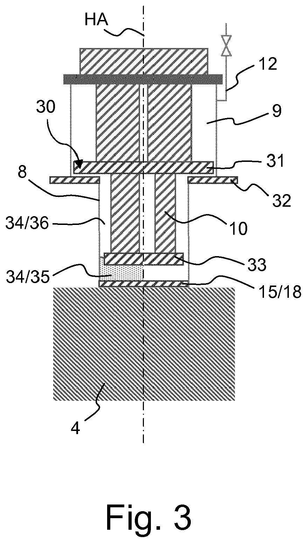

Fig. 3: mit Magnetspulenanordnung als zu kühlendem Objekt und Hohlraum unmittelbar den Kühlarm umgebend;

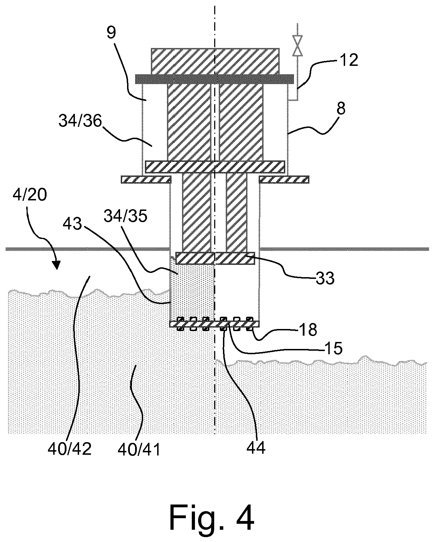

Fig. 4: mit Kryobehälter als zu kühlendem Objekt und Hohlraum unmittelbar den Kühlarm umgebend;

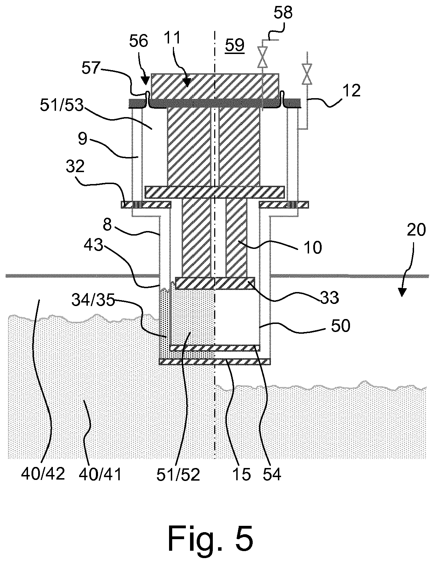

Fig. 5: mit Kühlarmbehälter unmittelbar den Kühlarm umgebend und Hohlraum umgebend den Kühlarmbehälter;

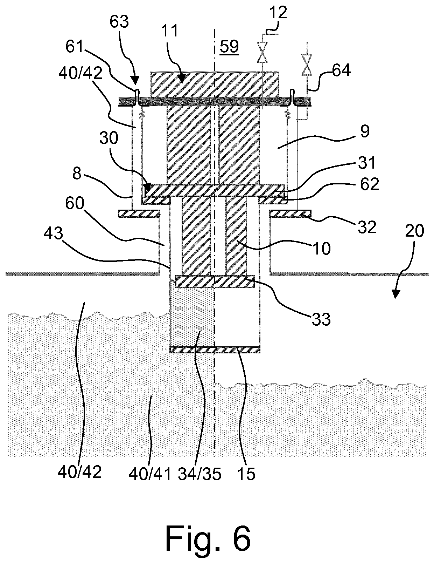

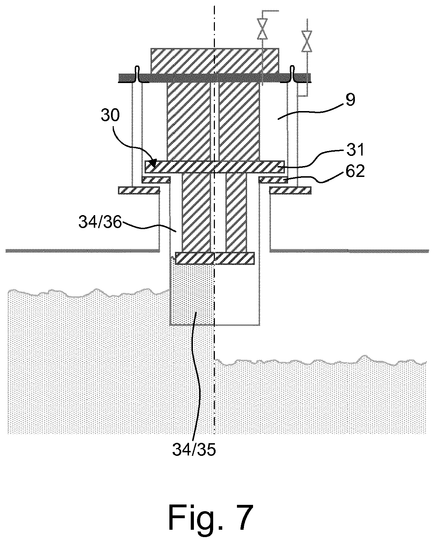

Fig. 6: mit Hohlraum unmittelbar den Kühlarm umgebend und Zwischenraum zwischen Einfassung des Hohlraums und Innenwand des Halsrohrs, mit direkter Schildankopplung; Fig. 7: mit Hohlraum unmittelbar den Kühlarm umgebend und Zwischenraum zwischen Einfassung des Hohlraums und Innenwand des Halsrohrs, mit Schildankopplung über das erste Kryofluid;

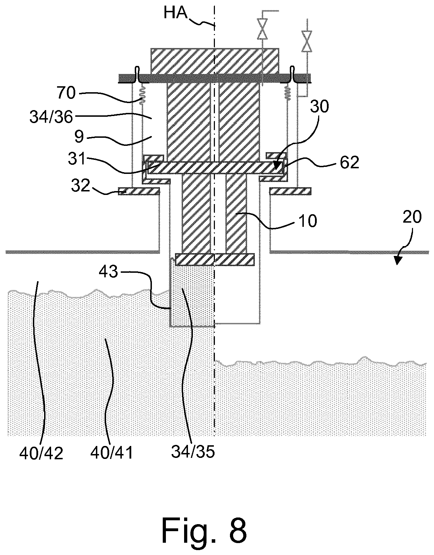

Fig. 8: mit Hohlraum unmittelbar umgebend den Kühlarm, mit elastischem längenveränderlichem Abschnitt der Einfassung des Hohlraums, und mit Zwischenraum zwischen der Einfassung des Hohlraums und der Innenwand des Halsrohrs;

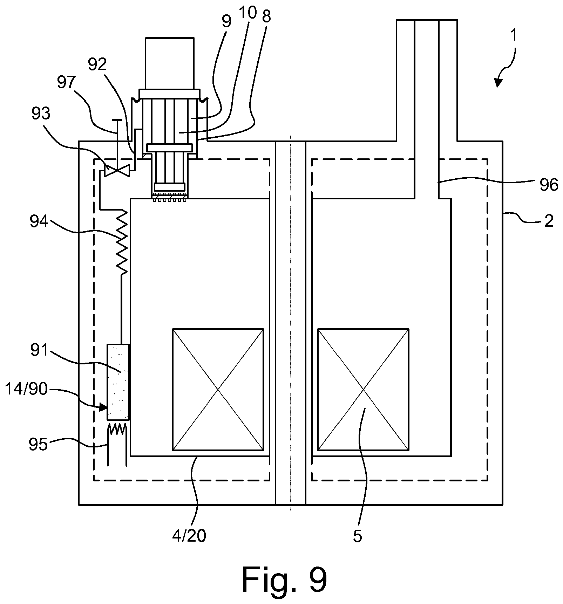

- Fig. 9: einen schematischen Querschnitt einer dritten Ausführungsform einer erfindungsgemäßen Kryostatenanordnung, mit Sorptionspumpe, deren pumpende Kaltflächen thermisch an das zu kühlende Objekt gekoppelt sind;

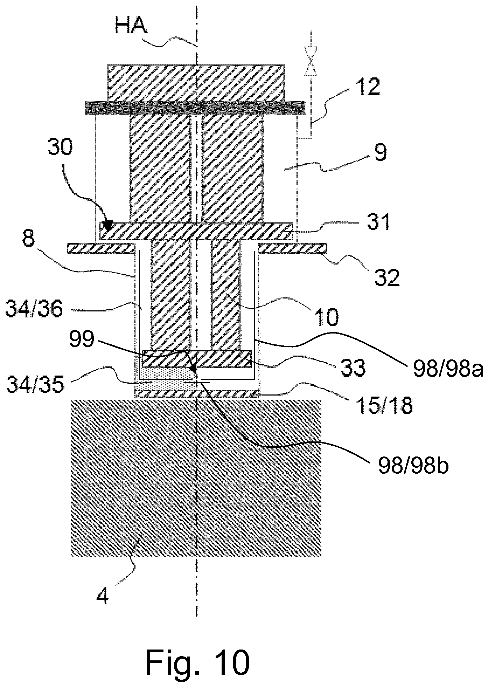

- Fig. 10: einen schematischen Querschnitt durch den Bereich des Halsrohrs einer erfindungsgemäßen Kryostatenanordnung entsprechend Fig. 3, zusätzlich mit offenem Strahlungsschild im Hohlraum.

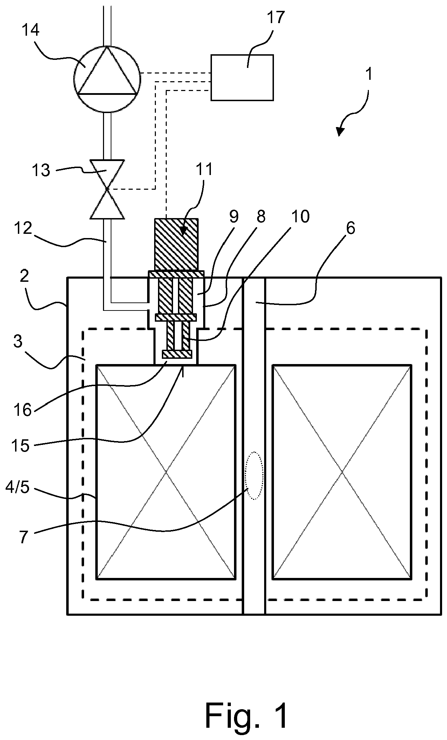

Die **Fig. 1** zeigt schematisch eine erste Ausführungsform einer erfindungsgemäßen Kryostatenanordnung 1, umfassend einen Vakuumbehälter 2, in dessen Innerem ein Vakuum eingerichtet ist. Im Vakuumbehälter 2 ist hier ein thermischer Strahlungsschild 3 (gestrichelt gezeichnet) angeordnet, der hier als zu kühlendes Objekt 4 ein supraleitendes Magnetspulensystem 5 umgibt. Das Magnetspulensystem 5 ist hier unmittelbar im Vakuum des Vakuumbehälters 2 angeordnet.

Die Kryostatenanordnung 1 ist mit einer Raumtemperaturbohrung 6 versehen, durch das ein Probenvolumen 7 im Zentrum des Magnetspulensystems 5 zugänglich ist. Im Probenvolumen 7 herrscht ein starkes, statisches, annähernd homogenes Magnetfeld B₀, das für NMR-Messungen an einer Probe im Probenvolumen 7 mit nicht näher dargestellten NMR-Resonatoren genutzt werden kann.

Durch den Vakuumbehälter 2 führt ein Halsrohr 8 zum zu kühlenden Objekt 4. In der gezeigten Ausführungsform bildet das Halsrohr 8 gleichzeitig die Einfassung eines Hohlraums 9, der einen Kühlarm 10 eines Kühlkopfs 11 eines aktiven Kühlsystems der Kryostatenanordnung 1 unmittelbar umgibt.

Der Hohlraum 9 ist über eine Pumpleitung 12 und ein Absperrventil 13 an eine Pumpvorrichtung 14 angeschlossen, mit der der Hohlraum 9 evakuiert werden kann. Zur Ansteuerung des Absperrventils 13 und der Pumpvorrichtung 14 ist eine Überwachungseinrichtung 17 vorgesehen, die auch Temperaturinformationen vom Kühlkopf 11 erhält, und hier bei Überschreiten einer Grenztemperatur (z.B. 10 K an einer untersten Kaltstufe des Kühlarms 11) selbsttätig das Steuerventil 13 öffnet und die Pumpvorrichtung 14 aktiviert.

Während eines Normalbetriebs der Kryostatenanordnung 1 ist der Hohlraum 9 zumindest teilweise mit einem ersten kryogenen Fluid (nicht näher dargestellt, vgl. aber Fig. 3ff) gefüllt, das den Kühlarm 10 mit dem zu kühlenden Objekt 4 über ein thermisches Kopplungsmittel 15 koppelt. Das thermische Kopplungsmittel 15 ist hier eine Oberseite des zu kühlenden Objekts 4, die gleichzeitig einen Teil der Einfassung des Hohlraums 9 bildet. Im Falle einer Störung der aktiven Kühlung des Kühlarms 10 wird der Hohlraum 9 mit der Pumpvorrichtung 14 evakuiert. Durch den evakuierten Abstandsraum 16 zwischen dem unteren Ende des Kühlarms 10 und dem thermischen Kopplungsmittel 15 tritt dann eine weitgehende thermische Entkopplung zwischen dem Kühlarm 10 und dem zu kühlenden Objekt 4 ein. Zu den Vorgängen bei der thermischen Entkopplung siehe auch Fig. 3 bis Fig. 8 weiter unten.

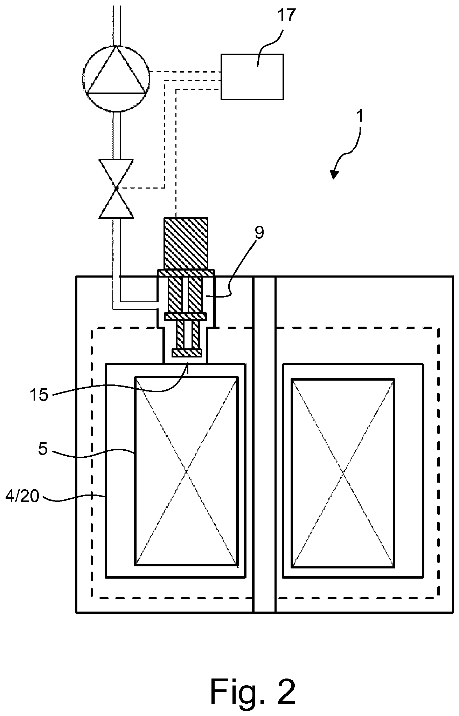

Die **Fig. 2** zeigt eine zweite Ausführungsform einer erfindungsgemäßen Kryostatenanordnung 1, die weitgehend der ersten Ausführungsform von Fig. 1 entspricht; es werden daher nur die wesentlichen Unterschiede erläutert.

In der zweiten Ausführungsform ist das zu kühlende Objekt 4 als ein Kryobehälter 20 ausgebildet, innerhalb dessen ein supraleitendes Magnetspulensystem 5 angeordnet ist. Weiterhin ist im Kryobehälter 20 ein zweites kryogenes Fluid, hier teilweise flüssiges und teilweise gasförmiges Helium (nicht näher dargestellt), angeordnet. Das supraleitende Magnetspulensystem 5 ist typischerweise zumindest teilweise in das flüssige Helium eingetaucht.

Die thermische Koppeleinrichtung 15 wird hier durch einen Teil der oberseitigen der Kryobehälterwand ausgebildet, die gleichzeitig den Hohlraum 9 begrenzt.

Die **Fig. 3** zeigt den Bereich des Halsrohrs 8 einer erfindungsgemäßen Kryostatenanordnung 1 näher, im Wesentlichen entsprechend der Ausführungsform von Fig. 1, mit einem fluiddichten Hohlraum 9, der den Kühlarm 10 unmittelbar umgibt. In der linken Hälfte ist der Zustand im Normalbetrieb gezeigt, und rechtsseitig der Zustand im Störungsfall (letzteres gilt für alle Figuren 3 bis 8 und 10).

Der Kühlarm 10 weist eine obere Kaltstufe (Kühlstufe) 30 mit einem oberen Kontaktelement 31 auf, das einem Schildkontaktelement 32 zu einem Strahlungsschild in geringem axialen Abstand gegenüber liegt (vgl. die Halsrohrachse HA). Weiterhin weist der Kühlarm 10 eine untere Kaltstufe (Kühlstufe) 33 auf, die dem thermischen Kopplungsmittel 15 in geringem axialen Abstand gegenüber liegt. Das Kopplungsmittel 15 ist hier ein Wärmetauscher 18, dessen Oberseite den Hohlraum 9 nach unten begrenzt und dessen Unterseite am zu kühlenden Objekt 4 anliegt.

Im Normalbetrieb (links) ist im Hohlraum 9 ein erstes kryogenes Fluid 34 bevorratet, das in einem unteren Bereich des Hohlraums 9 als erste kryogene Flüssigkeit 35 vorliegt, und im Raum darüber als erstes kryogenes Gas 36, typischerweise näherungsweise unter Normaldruck (ca. 1 bar). Die erste kryogene Flüssigkeit 35 steht so hoch, dass die untere Kaltstufe 33 in die erste kryogene Flüssigkeit 35 eintaucht. Dadurch wird eine starke thermische Kopplung zwischen der unteren Kaltstufe 33 des Kühlarms 10 und dem thermischen Kopplungsmittel 15 bzw. dem zu kühlenden Objekt 4 mit Wärmeübergangskoeffizient α eingerichtet. Das gasförmige kryogene Fluid 36 sorgt weiterhin für eine leidliche thermische Kopplung zwischen dem Schildkontaktelement 32 und dem oberen Kontaktelement 31.

Im Störungsfall (rechts), bei Ausfall der aktiven Kühlung, wird über die Pumpleitung 12 der Hohlraum 9 evakuiert (typischerweise auf weniger als 1 mbar). Dabei verdampft auch das erste flüssige kryogene Fluid 35. Das Vakuum zwischen der unteren Kaltstufe 33 und dem thermischen Kopplungsmittel 15 wirkt thermisch stark isolierend, und der Wärmeübergangskoeffizient α' fällt auf weniger als 1/100 des vormaligen Wärmeübergangskoeffizienten α. Auch wird die thermische Kopplung zwischen dem Schildkontaktelement 32 und dem oberen Kontaktelement 31 durch den evakuierten dazwischenliegenden axialen Spalt stark verringert. Dadurch bleibt das zu kühlende Objekt 4 länger kalt, insbesondere unterhalb einer Sprungtemperatur von enthaltenem Supraleiterdraht.

Die **Fig. 4** zeigt den Bereich eines Halsrohrs 8 einer erfindungsgemäßen Kryostatenanordnung ähnlich zu der in Fig. 3 gezeigten Ausführungsform, so dass nur die wesentlichen Unterschiede erläutert werden.

Das zu kühlende Objekt 4 ist hier ein Kryobehälter 20, der mit einem zweiten kryogenen Fluid 40 gefüllt ist, das teilweise als zweite kryogene Flüssigkeit 41 vorliegt, und teilweise als zweites kryogenes Gas 42. Im Kryobehälter 20 ist eine hier nicht näher dargestellte supraleitende Magnetspulenanordnung angeordnet. Der Gasdruck im Kryobehälter 20 kann durch einen Heizer (nicht näher dargestellt) im Kryobehälter 20 eingestellt werden.

Eine Einfassung 43 des Hohlraums 9 taucht im Normalbetrieb (links) in die zweite kryogene Flüssigkeit 41 ein. Der in die zweite kryogene Flüssigkeit 41 eintauchende Teil der Einfassung 43 kann hier als das thermische Kopplungsmittel 15 aufgefasst werden; zusätzlich ist hier der Boden der Einfassung 43 als Wärmetauscher 18 mit oberflächenvergrößernden Rippen 44 ausgebildet. Im Hohlraum 9 steht wiederum die erste kryogene Flüssigkeit 35 bis an die untere Kaltstufe 33 heran. Dadurch wird eine sehr gute thermische Kopplung von der zweiten kryogenen Flüssigkeit 41 über das thermische Kopplungsmittel 15 bzw. die Einfassung 43 und über die erste kryogene Flüssigkeit 35 bis an die untere Kaltstufe 33 des Kühlarms 10 erreicht.

Im Störfall wird der Hohlraum 9 über die Pumpleitung 12 evakuiert, wobei die erste kryogene Flüssigkeit 35 im Hohlraum 9 verdampft. Spätestens wenn der Spiegel an kryogener Flüssigkeit 41 im Kryobehälter 20 infolge von Verdampfung aus dem Kryobehälter 20 unter die Höhe des Bodens der Einfassung 43 gefallen ist, wird die thermische Kopplung zwischen dem Kryobehälter 20 und dem Kühlarm 10 bzw. dessen unterster Kühlstufe 33 sehr gering, da das Vakuum im Hohlraum 9 Wärme nicht oder kaum leitet, und das zweite gasförmige kryogene Fluid 42 deutlich schlechter Wärme leitet als das zweite flüssige kryogene Fluid 41.

Man beachte, dass in einer Variante auch das erste kryogene Fluid 34 im Hohlraum 9 vollständig gasförmig bleiben kann. In diesem Fall muss der Gasdruck im Hohlraum 9 entsprechend niedrig eingestellt sein, so dass es bei der an der unteren Kaltstufe 33 herrschenden Temperatur nicht zur Kondensation kommt.

Die in **Fig. 5** dargestellte Ausführungsform zeigt den Bereich eines Halsrohrs 8 einer erfindungsgemäßen Kryostatenanordnung in einer Ausführungsform ähnlich der in Fig. 4 gezeigten, so dass nachfolgend vor allem die Unterschiede erläutert werden.

Bei der Ausführungsform bildet außenseitig das Halsrohr 8 einen Teil der Einfassung 43 des Hohlraum 9 aus, und innenseitig wird der Hohlraum 9 durch die Wand eines Kühlarmbehälters 50 begrenzt, der den Kühlarm 10 enthält. Der Hohlraum 9 umgibt hier also mittelbar den Kühlarm 10.

Der Hohlraum 9 ist im Normalbetrieb (links) mit dem ersten kryogenen Fluid 34 gefüllt, zum Teil dabei als erste kryogene Flüssigkeit 35, so dass der Kühlarmbehälter 50 in die erste kryogene Flüssigkeit 35 eintaucht. Die Einfassung 43 taucht wiederum in die zweite kryogene Flüssigkeit 41 im Kryobehälter 20 ein. Im Kühlarmbehälter 50 ist ein drittes kryogenes Fluid 51 angeordnet, das teilweise als dritte kryogene Flüssigkeit 52 und teilweise als drittes kryogenes Gas 53 (bei ca. 1 bar) vorliegt. Das dritte kryogene Fluid 51 kann über den Fluidzugang/Überdruckablass 58 in den Kühlarmbehälter 50 eingefüllt oder aus diesem abgelassen werden; ggf. ist am Fluidzugang/Überdruckablass 58 ein Überdruckventil vorgesehen (nicht näher dargestellt). Die unterste Kühlstufe 33 des Kühlarms 10 taucht in die dritte kryogene Flüssigkeit 52 ein. Im Normalbetrieb ist so eine gute thermische Kopplung von der zweiten kryogenen Flüssigkeit 41 über die Einfassung 43 bzw. das erste thermische Kopplungsmittel 15, die erste kryogene Flüssigkeit 35, die Wand des Kühlarmbehälters 50 bzw. ein zweites thermisches Kopplungsmittel 54 und die dritte kryogene Flüssigkeit 52 zum Kühlarm 10 bzw. dessen unterster Kühlstufe 33 gegeben.

Bei einem Störungsfall (rechts) wird der Hohlraum 9, der den Kühlarmbehälter 50 umschließt, evakuiert; man beachte, dass das Schildkontaktelement 32 Durchbrüche (etwa axiale Bohrungen) aufweist, so dass auch der untere Teil des Hohlraums 9 über die Pumpleitung 12 evakuierbar ist. Durch Erwärmung des Kühlarms 10 wird die im Kühlarmbehälter 50 enthaltene dritte kryogene Flüssigkeit 52 erwärmt und verdampft; es verbleibt etwas Gas unter Normaldruck zurück. Auch sinkt durch Erwärmung und Verdampfung der Spiegel der zweiten kryogenen Flüssigkeit 41 im Kryobehälter 20 ab. Dann jedoch ist die thermische Kopplung zwischen Kryobehälter 20 und Kühlarm 10 nur noch gering, da das kryogene Gas 42 im Kryobehälter 20 sowie das Vakuum im Hohlraum 9 vergleichsweise schlechte Wärmeleiter sind. Der Hohlraum 9 wird auch als Wärmeschalter bezeichnet.

Bei dieser Ausführungsform kann ein Ringspalt 56 zwischen dem Kühlkopf 11 und der Wand des Kühlarmbehälters 50 mit einer flexiblen Membran 57 überspannt werden, um das Innere des Kühlarmbehälters 50 gegenüber der Umgebung 59 abzudichten. Aufgrund des Gasdrucks im Kühlarmbehälter 50 von ca. 1 bar (also entsprechend dem Umgebungsdruck) kann die flexible Membran 57 mechanisch näherungsweise spannungsfrei bleiben, so dass der Kaltkopf 11 in Verbindung mit einer schwingungsisolierenden Lagerung mechanisch gut von der übrigen Kryostatenanordnung entkoppelt werden kann. Dadurch sind störungsarme, insbesondere hochauflösende NMR-Messungen gut möglich.

In der **Fig. 6** wird eine Ausführungsform ähnlich der Fig. 4 gezeigt, so dass wiederum vor allem die Unterschiede erläutert werden. Der Hohlraum 9 umgibt hier unmittelbar den Kühlarm 10, wobei die Einfassung 43 des Hohlraums 9 von der Innenwand des Halsrohrs 8 in radialer Richtung beabstandet ist.

Dadurch ergibt sich ein Zwischenraum 60 zwischen der Einfassung 43 und der Innenwand des Halsrohrs 8. Dieser Zwischenraum 60 ist nach unten zum Kryobehälter 20 hin offen ausgebildet, so dass der Zwischenraum 60 mit dem zweiten kryogenen Fluid 40, nämlich mit dem zweiten kryogenen Gas 42 (bei etwa 1 bar), gefüllt ist. In den Zwischenraum 60 kann über die Zuführung 64 einzufüllendes oder rückzuführendes kryogenes Fluid (Helium) eingeleitet werden, das dann an der Außenseite der Einfassung 43 kondensieren und in den Kryobehälter 20 abtropfen kann (Alternativ kann auch kryogenes Fluid 40 an anderer Stelle im Kryostaten rückgeführt werden, also nicht entlang des Kühlarms 10, bevorzugt dann mit einem Gegenstromwärmetauscher, der die Enthalpie des aus einem Joule-Thomson-Refrigerator abgepumpten Heliums nutzt, um das rückgeführte Helium abzukühlen, nicht näher dargestellt).

Im Normalbetrieb (links) ist der Hohlraum 9 mit dem ersten kryogenen Fluid 34, teilweise als erstes kryogene Flüssigkeit 35, gefüllt. Im Störfall (rechts) wird der Hohlraum 9 über die Pumpleitung 12 evakuiert, um die thermische Kopplung vom Kryobehälter 20 zum Kühlarm 10 zu reduzieren, wie bei Fig. 4 erläutert.

Der Zwischenraum 60 wird zur Umgebung 59 hin (nach oben) mit einer flexiblen Membran 61 überspannt, um einen Ringspalt 63 zwischen Kaltkopf 11 (bzw. oberem Teil der Einfassung 43) und dem Halsrohr 8 (bzw. dem übrigen Kryostaten) abzudichten. Da im Zwischenraum 60 ein Gasdruck um 1 bar näherungsweise gleich dem Umgebungsdruck herrscht, kann die flexible Membran 61 mechanisch praktisch spannungsfrei gehalten werden, was die Übertragung von mechanischen Schwingungen reduziert. Bei schwingungsisolierender Lagerung des Kaltkopfs 11 sind dann NMR-Messungen, die bezüglich mechanischer Schwingungen praktisch störungsfrei sind, möglich.

In der gezeigten Bauform liegt das obere Kontaktelement 31 der oberen Kaltstufe 30 an einem Zwischenkontaktelement 62 der Einfassung 43 an. Dieses Zwischenkontaktelement 62 liegt dem Schildkontaktelement 32 gegenüber. Dadurch ist bei Normalbetrieb und im Störungsfall eine vergleichsweise starke thermische Kopplung zwischen dem Strahlungsschild am Schildkontaktelement 32 und der oberen Kühlstufe 30 am Kühlarm 10 eingerichtet.

Alternativ ist es auch möglich, wie in der Ausführungsform von **Fig. 7** gezeigt, die weitgehend der Bauform von Fig. 6 entspricht, so dass nur die wesentlichen Unterschiede erläutert werden, die obere Kaltstufe 30 (hier axial) beabstandet vom Zwischenkontaktelement 62 anzuordnen. In diesem Fall hängt die thermische Kopplung zwischen oberer Kühlstufe 30 bzw. deren oberen Kontaktelement 31 und dem Zwischenkontaktelement 62 vom Gasdruck im Hohlraum 9 ab. Im Normalbetrieb sorgt das erste kryogene Fluid 34, nämlich das erste kryogene Gas 36, für eine leidliche thermische Kopplung. Im Störungsfall, bei evakuiertem Hohlraum 9, ist die thermische Kopplung infolge des Vakuums im Abstandsraum zwischen oberem Kontaktelement 31 und Zwischenkontaktelement 62 gering.

Bei der in **Fig. 8** gezeigten Ausführungsform, die wiederum den Ausführungsformen von Fig. 6 und 7 ähnelt, so dass vor allem die Unterschiede erläutert werden, weist die Einfassung 43 einen elastisch längenveränderlichen Abschnitt 70 auf, so dass die Gesamterstreckung der Einfassung 43 in axialer Richtung (vgl. die Halsrohrachse HA) in den Kryobehälter 20 hinein veränderlich ist. Zudem weist die Einfassung 43 in der gezeigten Bauform ein nach Innen das obere Kontaktelement 31 der oberen Kühlstufe 30 umgreifendes Zwischenkontaktelement 62 auf.

Im Normalbetrieb (links) liegt hier eine Oberseite des oberen Kontaktelements 31 der oberen Kühlstufe 30 des (ortsfesten) Kühlarms 10 oberenseits am Zwischenkontaktelement 62 an, wodurch ein guter thermischer Kontakt zwischen der oberen Kühlstufe 30 und dem Zwischenkontaktelement 62 hergestellt ist. Zudem liegt der untere Teil des Zwischenkontaktelements 62 in kurzem axialen Abstand dem Schildkontaktelement 32 gegenüber, so dass (über das zweite kryogene Gas 42 des zweiten kryogenen Fluids 40) auch ein guter thermischer Kontakt vom Zwischenkontaktelement 62 zum Strahlungsschild geben ist. Der vergleichsweise hohe Gasdruck des ersten kryogenen Fluids 34 im Hohlraum 9 drückt dabei den unteren Teil der Einfassung 43 nach unten in den (ortsfesten) Kryotank 20 hinein.

Im Störungsfall (rechts) ist der Hohlraum 9 evakuiert. Der elastisch längenveränderliche Abschnitt 70 zieht sich infolge des verschwindenden Gasdrucks im Hohlraum 9 zusammen, und der untere Teil der Einfassung 43 einschließlich des Zwischenkontaktelements 62 wird etwas angehoben. Dadurch geht die berührende Anlage von oberem Kontaktelement 31 und Zwischenkontaktelement 62 verloren. Zum anderen vergrößert sich der gegenseitige Abstand von Schildkontaktelement 32 und Zwischenkontaktelement 62. Dadurch wird die thermische Kopplung von oberer Kühlstufe 30 und Strahlungsschild am Schildkontaktelement 32 stark verringert. Entsprechend wird die Wärmelast der Kryostatenanordnung durch den sich erwärmenden Kühlarm 10 weiter reduziert.

In der **Fig. 9** ist eine dritte Ausführungsform einer erfindungsgemäßen Kryostatenanordnung 1 ähnlich wie in Fig. 2 dargestellt abgebildet; es werden vor allem die wesentlichen Unterschiede erläutert.

Als Besonderheit ist hier die Pumpvorrichtung 14 als eine Sorptionspumpe 90 ausgebildet, umfassend einen Behälter 91 mit einer Aktivkohle- oder Zeolith-Füllung, wodurch eine große Adsorptionsfläche für kryogenes Fluid ausgebildet wird. Der Behälter 91 ist außenseitig an dem zu kühlenden Objekt 4, hier einem Kryobehälter 20, in welchem eine supraleitende Magnetspulenanordnung 5 positioniert ist, angeordnet. Entsprechend ist der Behälter 91 auf kryogener Temperatur und stellt pumpende Kaltflächen zur Verfügung. Vom Hohlraum 9, der hier den Kühlarm 10 unmittelbar umgibt und im Wesentlichen durch das Halsrohr 8 ausgebildet wird, führt eine Verbindungsleitung (Pumpleitung) 92 über ein Absperrventil 93 und einen Wärmetauscher 94 zum Behälter 91. Die Verbindungsleitung 92 verläuft hier vollständig innerhalb des Vakuumbehälters 2, wodurch die Verbindungsleitung 92 thermisch gut isoliert ist.

Im Störungsfall wird das Absperrventil 93 mit einer Steuereinrichtung 97 (die z.B. mechanisch, elektrisch oder pneumatisch ausgebildet sein kann) geöffnet, und erstes kryogenes Fluid strömt vom Hohlraum 9 in den Behälter 91 und wird dort gebunden. Die Sorptionspumpe 90 benötigt dabei keinen Betriebsstrom, so dass dieses Pumpprinzip auch gut anwendbar ist, wenn der Ausfall der aktiven Kühlung auf einem Stromausfall basiert. Das Absperrventil 93 kann nötigenfalls manuell geöffnet werden.

Die Sorptionspumpe 90 ist hier auch mit einem Heizer 95 ausgestattet, mit dem der Behälter 91 erwärmt werden kann, was gebundenes Fluid wieder freisetzt, wodurch der Behälter 91 regeneriert werden kann.

Die Kryostatenanordnung 1 verfügt hier über ein zusätzliches Rückführungshalsrohr 96, durch das der Kryobehälter 20 zugänglich ist, das für eine Zuführung oder Rückführung von zweitem Kryofluid (etwa Helium) genutzt werden kann.

Die **Fig. 10** zeigt den Bereich des Halsrohrs 8 einer erfindungsgemäßen Kryostatenanordnung ähnlich wie in Fig. 3 dargestellt, so dass nur die wesentlichen Unterschiede hierzu näher erläutert werden.

Im fluiddichten Hohlraum 9 ist ein offener Strahlungsschild 98 angeordnet, mit dem ein direkter Eintrag von Wärmestrahlung von sich im Störungsfall erwärmenden Bauteilen, hier dem Kühlarm 10, in das erste thermische Kopplungsmitel 15 blockiert wird.

Der Strahlungsschild 98 umgibt dazu einen unteren Teil (hier näherungsweise die untere Hälfte) des Kühlarms 10 und insbesondere auch die untere Kaltstufe 33. Der Strahlungsschild 98 ist zum einen nach oben (zur oberen Kaltstufe 30 hin) offen, ist aber auch nach unten hin fluiddurchlässig, so dass insbesondere die erste kryogene Flüssigkeit 35 von unten in das Innere des Strahlungsschilds 98 einfließen oder auch wieder ausfließen kann. Ein erster Teil 98a des Strahlungsschilds 98 ist dafür becherförmig nach oben hin offen, mit wenigstens einer Öffnung 99 an der Unterseite ausgebildet. Ein zweiter Teil 98b des Strahlungsschilds 98 ist vor dieser wenigstens einen Öffnung 99 angeordnet, so dass die wenigstens eine Öffnung 99 abgeschattet wird, insbesondere bezüglich der gesamten Breite des Wärmetauschers 18 bzw. des ersten thermischen Kopplungsmittels 15.

Dadurch wird im Störungsbetrieb ein direkter Eintrag von Wärmestrahlung vom Kühlarm 10 durch die wenigstens eine Öffnung 99 in den Wärmetauscher 18 verhindert. Der zweite Teil 98b des Strahlungsschilds 98 ist hier axial vom ersten Teil 98a beabstandet, so dass die erste kryogene Flüssigkeit 35 trotz der Abschattung von der Seite zwischen den zweiten Teil 98b und den ersten Teil 98a dringen und zur Öffnung 99 gelangen kann, und insbesondere im Normalbetrieb Konvektionsströmungen möglich sind.

### Bezugszeichenliste

- 1: Kryostatenanordnung
- 2: Vakuumbehälter
- 3: Thermischer Strahlungsschild
- 4: zu kühlendes Objekt
- 5: supraleitendes Magnetspulensystem
- 6: Raumtemperaturbohrung
- 7: Probenvolumen
- 8: Halsrohr
- 9: Hohlraum
- 10: Kühlarm
- 11: Kühlkopf (Kaltkopf)
- 12: Pumpleitung
- 13: Absperrventil
- 14: Pumpvorrichtung
- 15: erstes thermisches Kopplungsmittel
- 16: Abstandsraum
- 17: Überwachungseinrichtung
- 18: Wärmetauscher
- 20: Kryobehälter
- 30: obere Kaltstufe (Kühlstufe)
- 31: oberes Kontaktelement
- 32: Schildkontaktelement
- 33: untere Kaltstufe (Kühlstufe)
- 34: erstes kryogenes Fluid
- 35: erste kryogene Flüssigkeit
- 36: erstes kryogenes Gas
- 40: zweites kryogenes Fluid
- 41: zweite kryogene Flüssigkeit
- 42: zweites kryogenes Gas
- 43: Einfassung
- 44: Rippen
- 50: Kühlarmbehälter
- 51: drittes kryogenes Fluid
- 52: dritte kryogene Flüssigkeit
- 53: drittes kryogenes Gas
- 54: zweites thermisches Kopplungsmittel
- 56: Ringspalt (am Kühlarmbehälter)
- 57: flexible Membran (am Kühlarmbehälter)
- 58: Fluidzugang/Überdruckablass
- 59: Umgebung
- 60: Zwischenraum
- 61: flexible Membran (am Zwischenraum)
- 62: Zwischenkontaktelement
- 63: Ringspalt (am Zwischenraum)
- 64: Zuführung
- 70: elastisch längenveränderlicher Abschnitt
- 90: Sorptionspumpe
- 91: Behälter für pumpende Kaltflächen
- 92: Verbindungsleitung (Pumpleitung)
- 93: Absperrventil
- 94: Wärmetauscher
- 95: Heizer
- 96: zusätzliches Rückführungshalsrohr
- 97: Steuereinrichtung (für Absperrventil)
- 98: offener Strahlungsschild
- 98a: erster Teil des Strahlungsschilds
- 98b: zweiter Teil des Strahlungsschilds
- 99: Öffnung
- B₀: Magnetfeld
- HA: Halsrohrachse

## Patentansprüche

1. Kryostatenanordnung (1), mit einem Vakuumbehälter (2) und einem zu kühlenden Objekt (4), insbesondere einem supraleitenden Magnetspulensystem (5) oder einem Kryobehälter (20),
wobei das zu kühlende Objekt (4) innerhalb des Vakuumbehälters (2) angeordnet ist,
wobei der Vakuumbehälter (2) ein Halsrohr (8) aufweist, das zum zu kühlenden Objekt (4) führt,
wobei ein Kühlarm (10) eines Kaltkopfs (11) zumindest teilweise im Halsrohr (8) angeordnet ist,
wobei um den Kühlarm (10) herum ein abgeschlossener Hohlraum (9) ausgebildet ist, der gegenüber dem zu kühlenden Objekt (4) fluiddicht abgedichtet ist,
wobei der Hohlraum (9) im Normalbetrieb zumindest teilweise mit einem ersten kryogenen Fluid (34) gefüllt ist,
wobei ein erstes thermisches Kopplungsmittel (15) vorgesehen ist, geeignet zur thermischen Kopplung des ersten kryogenen Fluids (34) im Hohlraum (9) mit dem zu kühlenden Objekt (4),
wobei die Kryostatenanordnung (1) weiterhin eine Pumpvorrichtung (14) umfasst, an die der Hohlraum (9) angeschlossen ist,
**dadurch gekennzeichnet,**
**dass** eine Überwachungseinrichtung (17) vorgesehen ist, die die Kühlfunktion des Kaltkopfs (11) überwacht, und die dazu ausgebildet ist, bei Ausfall der Kühlfunktion des Kaltkopfs (11) die Pumpvorrichtung (14) selbsttätig zu aktivieren, so dass der Hohlraum (9) evakuiert wird.

2. Kryostatenanordnung (1) nach Anspruch 1, **dadurch gekennzeichnet, dass** der Kühlarm (10) des Kaltkopfs (11) unmittelbar in dem Hohlraum (9) angeordnet ist.

3. Kryostatenanordnung (1) nach Anspruch 2, **dadurch gekennzeichnet, dass** eine äußere Einfassung (43) des Hohlraums (9) von einer Innenwand des Halsrohrs (8) beabstandet ist, und ein Zwischenraum (60) zwischen der Innenwand des Halsrohrs (8) und der Einfassung (43) zum zu kühlenden Objekt (4) hin offen ausgebildet ist,
wobei das zu kühlende Objekt (4), zu dem der Zwischenraum (60) hin offen ist, ein Kryobehälter (20) ist, der zumindest teilweise mit einem zweiten kryogenen Fluid (40) gefüllt ist,
insbesondere wobei der Zwischenraum (60) eine Zuführung (64) für einzuführendes oder rückzuführendes zweites kryogenes Fluid (40) aufweist.

4. Kryostatenanordnung (1) nach Anspruch 3, **dadurch gekennzeichnet, dass** der Kaltkopf (11) einschließlich der Einfassung (43) des Hohlraums (9) von der übrigen Kryostatenanordnung (1) einschließlich des zu kühlenden Objekts (4) mechanisch entkoppelt gelagert ist, wobei eine flexible Membran (61) vorgesehen ist, die den Zwischenraum (60) gegenüber der Umgebung (59) abdichtet.

5. Kryostatenanordnung (1) nach Anspruch 1, **dadurch gekennzeichnet, dass** der Kühlarm (11) unmittelbar in einem Kühlarmbehälter (50) angeordnet ist, wobei der Hohlraum (9) um den Kühlarmbehälter (50) herum ausgebildet ist,
dass der Kühlarmbehälter (50) fluiddicht gegenüber dem Hohlraum (9) abgedichtet ist,
und dass ein zweites thermisches Kopplungsmittel (54) vorgesehen ist, geeignet zur thermischen Kopplung des ersten kryogenen Fluids (34) im Hohlraum (9) mit dem Innenraum des Kühlarmbehälters (50), insbesondere wobei im Kühlarmbehälter (50) ein drittes kryogenes Fluid (51) angeordnet ist.

6. Kryostatenanordnung (1) nach Anspruch 5, **dadurch gekennzeichnet, dass** der Kaltkopf (11) von der Wand des Kühlarmbehälters (50) und der übrigen Kryostatenanordnung (1) einschließlich des zu kühlenden Objekts (4) mechanisch entkoppelt gelagert ist, wobei eine flexible Membran (57) einen Ringspalt (56) zwischen der Wand des Kühlarmbehälters (50) und dem Kaltkopf (11) überspannt und so den Innenraum des Kühlarmbehälters (50) gegen die Umgebung (59) abdichtet.

7. Kryostatenanordnung (1) nach einem der vorhergehenden Ansprüche, **dadurch gekennzeichnet, dass** das zu kühlende Objekt (4) ein Kryobehälter (20) ist, und dass eine äußere Einfassung (43) des Hohlraums (9) in einen oberen Bereich des Kryobehälters (20) hineinragt.

8. Kryostatenanordnung (1) nach Anspruch 7, **dadurch gekennzeichnet, dass** im Normalbetrieb im Hohlraum (9) eine erste kryogene Flüssigkeit (35) angeordnet ist, dass im Kryobehälter (20) eine zweite kryogene Flüssigkeit (41) angeordnet ist, und dass die äußere Einfassung (43) des Hohlraums (9) in die zweite kryogene Flüssigkeit (41) im Kryobehälter (20) eintaucht.

9. Kryostatenanordnung (1) nach einem der Ansprüche 2 bis 4 und nach Anspruch 8, **dadurch gekennzeichnet, dass** zumindest eine unterste Kaltstufe (33) des Kühlarms (10) in die erste kryogene Flüssigkeit (35) im Hohlraum (9) eintaucht.

10. Kryostatenanordnung (1) nach den Ansprüchen 5 oder 6 und nach Anspruch 8, **dadurch gekennzeichnet, dass** der Kühlarmbehälter (50) in die erste kryogene Flüssigkeit (35) im Hohlraum (9) eintaucht, und dass im Kühlarmbehälter (50) eine dritte kryogene Flüssigkeit (52) angeordnet ist, in welche zumindest eine unterste Kaltstufe (33) des Kühlarms (10) eintaucht.

11. Kryostatenanordnung (1) nach einem der vorhergehenden Ansprüche, **dadurch gekennzeichnet, dass** die Pumpvorrichtung (14) als eine Sorptionspumpe (90) ausgebildet ist, deren pumpende Kaltflächen thermisch an das zu kühlende Objekt (4) gekoppelt sind, insbesondere wobei eine Verbindungsleitung (92) vom Hohlraum (9) zu den pumpenden Kaltflächen vollständig innerhalb des Vakuumbehälters (2) verläuft.

12. Kryostatenanordnung (1) nach einem der Ansprüche 1 bis 11, **dadurch gekennzeichnet, dass** es sich bei dem zu kühlenden Objekt (4) um einen Kryobehälter (20) handelt, der zumindest teilweise mit einem zweiten kryogenen Fluid (40) gefüllt ist, insbesondere wobei in dem Kryobehälter (20) ein supraleitendes Magnetspulensystem (5) angeordnet ist.

13. Kryostatenanordnung (1) nach einem der Ansprüche 1, 2, 5, 6 oder 11, **dadurch gekennzeichnet, dass** es sich bei dem zu kühlenden Objekt (4) um ein supraleitendes Magnetspulensystem (5) handelt, das unmittelbar im Vakuumbehälter (2) angeordnet ist.

14. Verfahren zum Betrieb einer Kryostatenanordnung (1), insbesondere einer Kryostatenanordnung (1) nach einem der vorhergehenden Ansprüche, mit einem Vakuumbehälter (2) und einem zu kühlenden Objekt (4), insbesondere einem supraleitenden Magnetspulensystem (5) oder einem Kryobehälter (20),
wobei das zu kühlende Objekt (4) innerhalb des Vakuumbehälters (2) angeordnet ist,
wobei der Vakuumbehälter (2) ein Halsrohr (8) aufweist, das zum zu kühlenden Objekt (4) führt,
wobei ein Kühlarm (10) eines Kaltkopfs (11) zumindest teilweise im Halsrohr (8) angeordnet ist,
wobei um den Kühlarm (10) herum ein abgeschlossener Hohlraum (9) ausgebildet ist, der gegenüber dem zu kühlenden Objekt (4) fluiddicht abgedichtet ist,
wobei eine erstes thermisches Kopplungsmittel (15) vorgesehen ist, geeignet zur thermischen Kopplung eines ersten kryogenen Fluids (34) im Hohlraum (9) mit dem zu kühlenden Objekt (4),
wobei in einem Normalbetrieb die Kryostatenanordnung (1) mit einer zumindest teilweisen Befüllung des Hohlraums (9) mit erstem kryogenen Fluid (34) betrieben wird,
und wobei die Kryostatenanordnung (1) weiterhin eine Pumpvorrichtung (14) umfasst, an die der Hohlraum (9) angeschlossen ist,
**dadurch gekennzeichnet,**
**dass** die Kühlfunktion des Kaltkopfs (11) mit einer Überwachungseinrichtung (17) überwacht wird,
und **dass** bei Ausfall der Kühlfunktion des Kaltkopfs (11) die Überwachungseinrichtung (17) die Pumpvorrichtung (14) selbsttätig aktiviert, so dass der Hohlraum (9) evakuiert wird.

15. Verfahren nach Anspruch 14, **dadurch gekennzeichnet, dass** die Überwachungseinrichtung (17) eine Temperatur am Kühlarm (10) überwacht.

## Claims

1. A cryostat arrangement (1), with a vacuum container (2) and an object (4) to be cooled, in particular a superconducting magnetic coil system (5) or a cryocontainer (20),
wherein the object (4) to be cooled is arranged inside the vacuum container (2),
wherein the vacuum container (2) comprises a neck tube (8), leading to the object (4) to be cooled,
wherein a cooling arm (10) of a cold head (11) is arranged at least partly in the neck tube (8),
wherein a closed cavity (9) is formed around the cooling arm (10), being sealed off fluid-tight against the object (4) to be cooled,
wherein the cavity (9) in normal operation is filled at least partly with a first cryogenic fluid (34),
wherein a first thermal coupling means (15) is provided, suitable for the thermal coupling of the first cryogenic fluid (34) in the cavity (9) to the object (4) to be cooled,
wherein the cryostat arrangement (1) furthermore comprises a pump device (14), to which the cavity (9) is connected, **characterized in that**
a monitoring device (17) is provided, which monitors the cooling function of the cold head (11), and which is designed to automatically activate the pump device (14) upon failure of the cooling function of the cold head (11), so that the cavity (9) is evacuated.

2. The cryostat arrangement (1) as claimed in claim 1,
**characterized in that** the cooling arm (10) of the cold head (11) is arranged directly in the cavity (9).

3. The cryostat arrangement (1) as claimed in claim 2,
**characterized in that** an outer enclosure (43) of the cavity (9) is spaced apart from an inner wall of the neck tube (8), and an intermediate space (60) is formed between the inner wall of the neck tube (8) and the enclosure (43), open toward the object (4) to be cooled,
wherein the object (4) to be cooled toward which the intermediate space (60) is open is a cryocontainer (20), which is filled at least partly with a second cryogenic fluid (40),
in particular wherein the intermediate space (60) comprises a feed line (64) for second cryogenic fluid (40) to be introduced or returned.

4. The cryostat arrangement (1) as claimed in claim 3,
**characterized in that** the cold head (11) including the enclosure (43) of the cavity (9) is mounted such as to be mechanically decoupled from the rest of the cryostat arrangement (1) including the object (4) to be cooled, wherein a flexible membrane (61) is provided, which seals off the intermediate space (60) against the surroundings (59).

5. The cryostat arrangement (1) as claimed in claim 1,
**characterized in that**
the cooling arm (11) is arranged directly in a cooling arm container (50), wherein the cavity (9) is formed around the cooling arm container (50),
the cooling arm container (50) is sealed off fluid-tight against the cavity (9),
and a second thermal coupling means (54) is provided, suitable for the thermal coupling of the first cryogenic fluid (34) in the cavity (9) to the interior of the cooling arm container (50),
in particular wherein a third cryogenic fluid (51) is arranged in the cooling arm container (50).

6. The cryostat arrangement (1) as claimed in claim 5,
**characterized in that** the cold head (11) is mounted so as to be mechanically decoupled from the wall of the cooling arm container (50) and the rest of the cryostat arrangement (1) including the object (4) to be cooled, wherein a flexible membrane (57) spans an annular gap (56) between the wall of the cooling arm container (50) and the cold head (11) and thus seals off the interior of the cooling arm container (50) against the surroundings (59).

7. The cryostat arrangement (1) as claimed in one of the
preceding claims, **characterized in that** the object (4) to be cooled is a cryocontainer (20), and an outer enclosure (43) of the cavity (9) protrudes into an upper region of the cryocontainer (20).

8. The cryostat arrangement (1) as claimed in claim 7,
**characterized in that** a first cryogenic liquid (35) is arranged in the cavity (9) in normal operation, a second cryogenic liquid (41) is arranged in the cryocontainer (20), and the outer enclosure (43) of the cavity (9) is submerged in the second cryogenic liquid (41) in the cryocontainer (20).

9. The cryostat arrangement (1) as claimed in one of claims 2 to 4 and as claimed in claim 8, **characterized in that** at least a lowermost cold stage (33) of the cooling arm (10) is submerged in the first cryogenic liquid (35) in the cavity (9).

10. The cryostat arrangement (1) as claimed in claims 5 or 6 and as claimed in claim 8, **characterized in that** the cooling arm container (50) is submerged in the first cryogenic liquid (35) in the cavity (9), and a third cryogenic liquid (52) is arranged in the cooling arm container (50), in which at least a lowermost cold stage (33) of the cooling arm (10) is submerged.

11. The cryostat arrangement (1) as claimed in one of the preceding claims, **characterized in that** the pump device (14) is designed as a sorption pump (90), whose pumping cold surfaces are thermally coupled to the object (4) to be cooled,
in particular wherein a connection line (92) runs from the cavity (9) to the pumping cold surfaces entirely inside the vacuum container (2).

12. The cryostat arrangement (1) as claimed in one of claims 1 to 11, **characterized in that** the object (4) to be cooled is a cryocontainer (20), which is filled at least partly with a second cryogenic fluid (40), in particular wherein a superconducting magnetic coil system (5) is arranged in the cryocontainer (20).

13. The cryostat arrangement (1) as claimed in one of claims 1, 2, 5, 6 or 11, **characterized in that** the object (4) to be cooled is a superconducting magnetic coil system (5), which is arranged directly in the vacuum container (2).

14. A method for operating a cryostat arrangement (1), in particular a cryostat arrangement (1) as claimed in one of the preceding claims, with a vacuum container (2) and an object (4) to be cooled, in particular a superconducting magnetic coil system (5) or a cryocontainer (20),
wherein the object (4) to be cooled is arranged inside the vacuum container (2),
wherein the vacuum container (2) comprises a neck tube (8), leading to the object (4) to be cooled,
wherein a cooling arm (10) of a cold head (11) is arranged at least partly in the neck tube (8),
wherein a closed cavity (9) is formed around the cooling arm (10), being sealed off fluid-tight against the object (4) to be cooled,
wherein a first thermal coupling means (15) is provided, suitable for the thermal coupling of a first cryogenic fluid (34) in the cavity (9) to the object (4) to be cooled,
wherein the cryostat arrangement (1) in normal operation is operated with an at least partial filling of the cavity (9) with a first cryogenic fluid (34),
and wherein the cryostat arrangement (1) furthermore comprises a pump device (14) to which the cavity (9) is connected, **characterized in that**
the cooling function of the cold head (11) is monitored by a monitoring device (17),
and that upon failure of the cooling function of the cold head (11) the monitoring device (17) automatically activates the pump device (14) so that the cavity (9) is evacuated.

15. A method as claimed in claim 14, **characterized in that** the monitoring device (17) monitors a temperature on the cooling arm (10).

## Revendications

1. Ensemble de cryostat (1), doté d'un réservoir à vide (2) et d'un objet à refroidir (4), en particulier d'un système de bobine magnétique supraconductrice (5) ou d'un réservoir cryogénique (20),
dans lequel l'objet à refroidir (4) est disposé à l'intérieur du réservoir à vide (2),
dans lequel le réservoir à vide (2) présente un col tubulaire (8), qui conduit à l'objet à refroidir (4), dans lequel un bras de refroidissement (10) d'une tête froide (11) est disposé au moins en partie dans le col tubulaire (8),
dans lequel une cavité fermée (9) est formée autour du bras de refroidissement (10), laquelle est étanche au fluide par rapport à l'objet à refroidir (4),
dans lequel la cavité (9) est en fonctionnement normal au moins partiellement remplie avec un premier fluide cryogénique (34),
dans lequel il est prévu un premier moyen de couplage thermique (15), approprié pour le couplage thermique du premier fluide cryogénique (34) dans la cavité (9) avec l'objet à refroidir (4),
dans lequel l'ensemble de cryostat (1) comprend en outre un dispositif de pompe (14), auquel la cavité (9) est raccordée,
**caractérisé en ce qu'**il est prévu un dispositif de surveillance (17), qui surveille la fonction de refroidissement de la tête froide (11), et qui est configuré pour activer automatiquement le dispositif de pompe (14) en cas de panne de la fonction de refroidissement de la tête froide (11), de telle manière que la cavité (9) soit évacuée.

2. Ensemble de cryostat (1) selon la revendication 1, **caractérisé en ce que** le bras de refroidissement (10) de la tête froide (11) est disposé directement dans la cavité (9).

3. Ensemble de cryostat (1) selon la revendication 2, **caractérisé en ce qu'**une enveloppe extérieure (43) de la cavité (9) est espacée d'une paroi intérieure du col tubulaire (8), et un espace intermédiaire (60) entre la paroi intérieure du col tubulaire (8) et l'enveloppe (43) est ouvert en direction de l'objet à refroidir (4), dans lequel l'objet à refroidir (4), vers lequel l'espace intermédiaire (60) est ouvert, est un réservoir cryogénique (20), qui est rempli au moins partiellement avec un deuxième fluide cryogénique (40),
en particulier dans lequel l'espace intermédiaire (60) présente une arrivée (64) pour un deuxième fluide cryogénique à introduire ou à renvoyer (40).

4. Ensemble de cryostat (1) selon la revendication 3, **caractérisé en ce que** la tête froide (11) y compris l'enveloppe (43) de la cavité (9) est montée de façon mécaniquement découplée du reste de l'ensemble de cryostat (1) y compris de l'objet à refroidir (4), dans lequel il est prévu une membrane flexible (61), qui assure l'étanchéité de l'espace intermédiaire (60) par rapport à l'environnement (59).

5. Ensemble de cryostat (1) selon la revendication 1, **caractérisé en ce que** le bras de refroidissement (11) est disposé directement dans un réservoir de bras de refroidissement (50), dans lequel la cavité (9) est formée autour du réservoir de bras de refroidissement (50), **en ce que** le réservoir de bras de refroidissement (50) est étanche au fluide par rapport à la cavité (9), et **en ce qu'**il est prévu un second moyen de couplage thermique (54), approprié pour le couplage thermique du premier fluide cryogénique (34) dans la cavité (9) avec l'espace intérieur du réservoir de bras de refroidissement (50), en particulier dans lequel un troisième fluide cryogénique (51) est disposé dans le réservoir de bras de refroidissement (50).

6. Ensemble de cryostat (1) selon la revendication 5, **caractérisé en ce que** la tête froide (11) est montée de façon mécaniquement découplée de la paroi du réservoir de bras de refroidissement (50) et du reste de l'ensemble de cryostat (1) y compris de l'objet à refroidir (4), dans lequel une membrane flexible (57) recouvre une fente annulaire (56) entre la paroi du réservoir de bras de refroidissement (50) et la tête froide (11) et assure ainsi l'étanchéité de l'espace intérieur du réservoir de bras de refroidissement (50) par rapport à l'environnement (59).

7. Ensemble de cryostat (1) selon l'une quelconque des revendications précédentes, **caractérisé en ce que** l'objet à refroidir (4) est un réservoir cryogénique (20), et **en ce qu'**une enveloppe extérieure (43) de la cavité (9) pénètre dans une région supérieure du réservoir cryogénique (20).

8. Ensemble de cryostat (1) selon la revendication 7, **caractérisé en ce qu'**en fonctionnement normal un premier liquide cryogénique (35) est disposé dans la cavité (9), **en ce qu'**un deuxième liquide cryogénique (41) est disposé dans le réservoir cryogénique (20) et **en ce que** l'enveloppe extérieure (43) de la cavité (9) plonge dans le deuxième liquide cryogénique (41) dans le réservoir cryogénique (20).

9. Ensemble de cryostat (1) selon l'une quelconque des revendications 2 à 4 et selon la revendication 8, **caractérisé en ce qu'**au moins un étage froid inférieur (33) du bras de refroidissement (10) plonge dans le premier liquide cryogénique (35) dans la cavité (9).

10. Ensemble de cryostat (1) selon une des revendications 5 ou 6 et selon la revendication 8, **caractérisé en ce que** le réservoir de bras de refroidissement (50) plonge dans le premier liquide cryogénique (35) dans la cavité (9), et **en ce qu'**un troisième liquide cryogénique (52) est disposé dans le réservoir de bras de refroidissement (50), dans lequel plonge au moins un étage froid inférieur (33) du bras de refroidissement (10).

11. Ensemble de cryostat (1) selon l'une quelconque des revendications précédentes, **caractérisé en ce que** le dispositif de pompe (14) est formé par une pompe à sorption (90), dont les faces de pompage froides sont couplées thermiquement à l'objet à refroidir (4), en particulier dans lequel une conduite de liaison (92) s'étend de la cavité (9) aux faces de pompage froides entièrement à l'intérieur du réservoir à vide (2).

12. Ensemble de cryostat (1) selon l'une quelconque des revendications 1 à 11, **caractérisé en ce que** l'objet à refroidir (4) est un réservoir cryogénique (20), qui est au moins partiellement rempli avec un deuxième fluide cryogénique (40), en particulier dans lequel un système de bobine magnétique supraconductrice (5) est disposé dans le réservoir cryogénique (20).

13. Ensemble de cryostat (1) selon l'une quelconque des revendications 1, 2, 5, 6 ou 11, **caractérisé en ce que** l'objet à refroidir (4) est un système de bobine magnétique supraconductrice (5), qui est disposé directement dans le réservoir à vide (2).

14. Procédé de fonctionnement d'un ensemble de cryostat (1), en particulier d'un ensemble de cryostat (1) selon l'une quelconque des revendications précédentes, doté d'un réservoir à vide (2) et d'un objet à refroidir (4), en particulier d'un système de bobine magnétique supraconductrice (5) ou d'un réservoir cryogénique (20), dans lequel l'objet à refroidir (4) est disposé à l'intérieur du réservoir à vide (2),
dans lequel le réservoir à vide (2) présente un col tubulaire (8), qui conduit à l'objet à refroidir (4), dans lequel un bras de refroidissement (10) d'une tête froide (11) est disposé au moins en partie dans le col tubulaire (8),
dans lequel une cavité fermée (9) est formée autour du bras de refroidissement (10), laquelle est étanche au fluide par rapport à l'objet à refroidir (4),
dans lequel il est prévu un premier moyen de couplage thermique (15), approprié pour le couplage thermique d'un premier fluide cryogénique (34) dans la cavité (9) avec l'objet à refroidir (4),
dans lequel dans un fonctionnement normal l'ensemble de cryostat (1) fonctionne avec un remplissage au moins partiel de la cavité (9) avec un premier fluide cryogénique (34), et
dans lequel l'ensemble de cryostat (1) comprend en outre un dispositif de pompe (14), auquel la cavité (9) est raccordée,
**caractérisé en ce que** l'on surveille la fonction de refroidissement de la tête froide (11) avec un dispositif de surveillance (17), et **en ce que** le dispositif de surveillance (17) active automatiquement le dispositif de pompe (14) en cas de panne de la fonction de refroidissement de la tête froide (11), de telle manière que la cavité (9) soit évacuée.

15. Procédé selon la revendication 14, **caractérisé en ce que** le dispositif de surveillance (17) surveille une température au bras de refroidissement (10).
